Europäisches Patentamt

(19) European Patent Office

Office européen des brevets

(11) Numéro de publication: **0 002 165**
**B1**

(12) **FASCICULE DE BREVET EUROPEEN**

(45) Date de publication du fascicule du brevet: **06.01.82**

(21) Numéro de dépôt: **78430014.7**

(22) Date de dépôt: **04.10.78**

(51) Int. Cl.³: **H 01 L 21/88,**
**H 01 L 21/60,**
**H 01 L 29/76, H 01 L 23/52**

(54) **Procédé de fabrication d'une structure de conducteurs et application aux transistors à effet de champ.**

(30) Priorité: **11.11.77 US 850586**

(43) Date de publication de la demande:
**30.05.79 Bulletin 79/11**

(45) Mention de la délivrance du brevet:
**06.01.82 Bulletin 82/1**

(84) Etats contractants désignés:
**DE FR GB**

(56) Documents cités:
**DE - A - 2 216 338**
**DE - A - 2 525 482**
**US - A - 4 102 733**

**IBM TECHNICAL DISCLOSURE BULLETIN, vol.
17, n° 6, November 1974,
Armonk, N.Y.,
V. L. RIDEOUT "Reducing the sheet resistance
of polysilicon lines in integrated circuits" pages
1831 à 1833**

(73) Titulaire: **International Business Machines
Corporation
Armonk, N.Y. 10504 (US)**

(72) Inventeur: **Gaensslen, Fritz Heinrich
RFD No.1, Hanover Street
Yorktown Heights New York 10598 (US)**

(74) Mandataire: **Klein, Daniel
COMPAGNIE IBM FRANCE Département de
Propriété Industrielle
F-06610 La Gaude (FR)**

Courier Press, Leamington Spa, England.

Procédé de fabrication d'une structure de conducteurs et application
aux transistors à effet de champ

Domaine Technique

La présente invention concerne un procédé de fabrication d'une structure composite de conducteurs et, plus particulièrement, son application aux transistors à effet de champ du type métal-oxyde-semi-conducteur à porte isolée et auto-alignée. Cette structure composite est constituée par une couche d'un siliciure disposée entre deux couches de polysilicium.

Etat de la technique antérieure

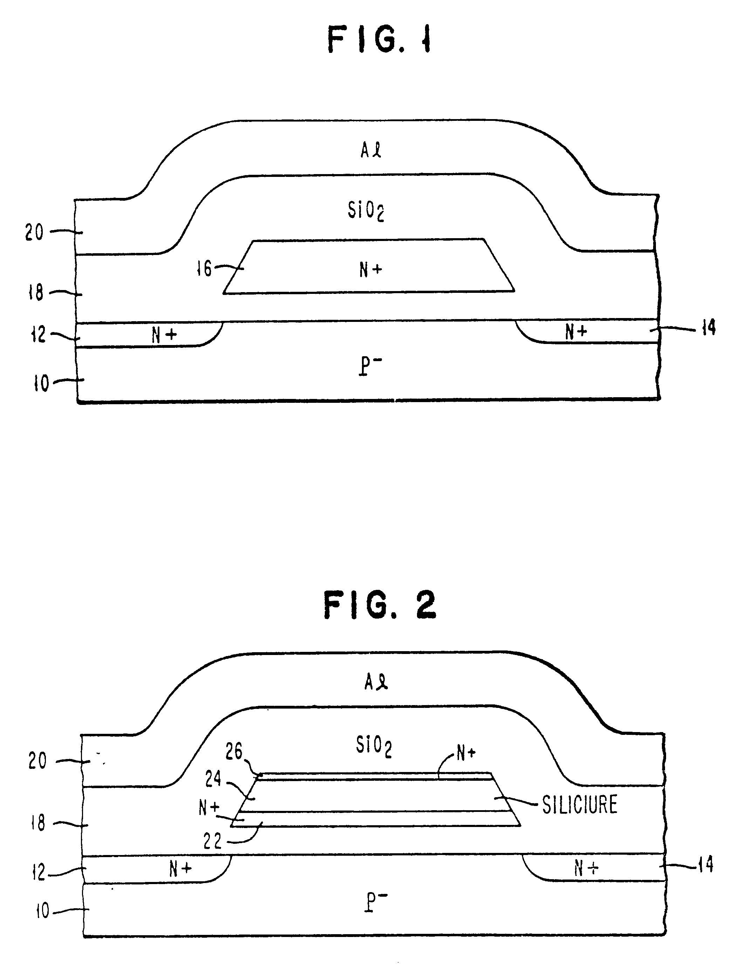

Dans les procédés connus de fabrication de circuits intégrés, et notamment dans le cas du procédé classique de fabrication de portes auto-alignées, l'élément constituant la porte, lequel est exposé à des températures élevées lors de l'étape de diffusion qui permet de réaliser les électrodes de source et de drain, est généralement constitué par du polysilicium (silicium polycristallin) car ce dernier matériau offre la même résistance aux températures élevées que les métaux réfractaires. Ce procédé classique de fabrication de portes auto-alignées comporte généralement une étape de réoxydation qui permet de former une couche d'oxyde au-dessus de la porte afin de séparer cette dernière des conducteurs métalliques ultérieurement disposés au-dessus de l'ensemble, et il est plus facile de faire croître cet oxyde sur du polysilicium que sur un métal réfractaire. Une structure classique de ce type dont la porte est constituée par du polysilicium est représentée sur la figure 1.

Toutefois, l'emploi d'une porte en polysilicium présente l'inconvénient, par rapport à une porte en métal réfractaire, de nécessiter dans de nombreuses applications, l'établissement d'une connexion entre la porte et la couche supérieure de conducteurs métalliques de manière à obtenir une distribution à deux niveaux des signaux. En outre, la résistance de feuille du polysilicium est supérieure à celle du métal, ce qui entraîne, entre autres inconvénients, une diminution de la vitesse du circuit. Diverses tentatives ont été faites dans l'art antérieure pour résoudre ce problème. L'article de V. L. Rideout intitulé "Reducing the Sheet Resis-tance of Polysilicon Lines In Integrated Circuits" paru dans la publication intitulée "IBM Technical Disclosure Bulletin", Vol. 17, No. 6, novembre 1974, préconise l'emploi de conducteurs en polysilicium dans des circuits intégrés multicouches en raison de la stabilité offerte par le polysilicium aux températures élevées et du fait que l'on peut déposer ou faire croître sur celui-ci, du dioxyde de silicium. Selon ce même article, on peut diminuer la résistance des conducteurs en polysilicium en formant une couche de siliciure présentant une conductivité élevée sur la surface exposée de ces conducteurs, c'est-à-dire aux points où le métal et le polysilicium sont en contact. Plus particulièrement, les conducteurs en polysilicium sont formés sur une couche de dioxyde de silicium recouvrant un substrat, un métal tel que du hafnium est déposée sur l'ensemble, du sili-ciure de hafnium est formé sur le conducteur en polysilicium, mais le hafnium ne réagit pas avec le dioxyde de silicium et est retiré par décapage. Finalement une couche isolante en dioxyde de silicium et une couche d'aluminium sont déposées.

Exposé de l'invention

La présente invention, dans un aspect particulier, diffère de l'art antérieur en ce qu'elle prévoit la formation successive, selon des techniques connues relevant de la fabrication des transistors à effet de champ à porte auto-alignée d'une première couche de polysilicium, d'une couche d'un métal formant un siliciure, et d'une seconde couche de polysilicium. Après masquage, et pendant le processus ultérieur de réoxydation, la couche métallique réagit sur ses deux surfaces avec les couches de polysilicium, et une région de siliciure est alors formée. Cette dernière permettra d'établir des connexions avec une couche métallique supérieure qui sera réalisée ultérieurement, la structure composite de porte obtenue conformément à la présente invention est stable en température et la couche supérieure de polysilicium qu'elle comporte, assure une croissance satisfaisante de l'oxyde lors de l'étape de réoxydation.

La présente invention a donc pour but un procédé de fabrication d'une structure composite de conducteurs qui soit stable lorsqu'elle est exposée à des températures élevées, qui présente une faible résistance de feuille et sur laquelle un oxyde peut être formé de façon efficace.

Un autre objet de la présente invention est de fournir une structure de porte offrant une faible résistance de feuille.

Un autre object de la présente invention est un procédé de fabrication d'une structure de porte pour transistors à effet de champ qui permette d'obtenir une fonction de travail différente de celle d'un substrat en silicium.

En conclusion la présente invention a pour but principal de fournir un procédé de fabrication d'une structure composite pouvant servir de porte pour transistors à effet de champ et également de conducteurs pour les circuits intégrés. Cette structure comprend une couche d'un métal formant un siliciure, disposée entre deux couches de polysilicium, dans laquelle le métal réagit avec le polysilicium pour former un siliciure.

D'autres objets, caractéristiques et avantages de la présente invention ressortiront mieux de l'exposé qui suit, fait en référence aux dessins annexés à ce texte, qui représentent un mode de réalisation préféré de celle-ci.

### Brève description des figures

La figure 1 représente schématiquement un transistor classique à effet de champ du type métal-oxyde-semi-conducteur à porte auto-alignée.

La figure 2 représente schématiquement un transistor analogue à celui de la figure 1 dont la porte comprend une couche d'un métal formant un siliciure disposée entre deux couches de polysilicium conformément aux principes de la présente invention.

### Description d'un mode détaillé de réalisation

Le dispositif représenté sur la figure 1 comprend un substrat 10 de type P et des régions de source et de drain 12 et 14 de type $N^+$. Une électrode de porte 16 en polysilicium de type $N^+$ est enterrée dans une couche isolante 18 en dioxyde de silicium ($SiO_2$) dont une partie constitue l'isolant de porte. Le dispositif peut être recouvert d'une couche métallique 20.

La couche 16 n'est pas en métal réfractaire, mais en polysilicium parce que ce dernier matériau est stable aux températures élevées et parce qu'on peut faire croître thermiquement ou déposer chimiquement en phase vapeur, du dioxyde de silicium. Toutefois, la résistance de feuille du polysilicium est de plusieurs ordres de grandeur supérieure à celle de la couche métallique supérieure 20, d'où une non concordance des conductivités respectives qui entraîne notamment une diminution de la vitesse du circuit lorsque la couche de polysilicium dont fait partie la porte 16, est également employée comme élément du réseau d'interconnexion, de même que la couche métallique normale 20. L'emploi, comme porte du dispositif, d'un métal réfractaire offre l'avantage d'un concordance des conductivités mais a pour inconvénient le fait qu'il y est difficile de faire croître de l'oxyde.

Le dispositif représenté sur la figure 2 comprend un substrat 10, une source 12, un drain 14 et une couche isolante 18 analogues aux éléments correspondants de la figure 1. Toutefois, la porte comprend une première couche de polysilicium 22 dont l'épaisseur est égale à la moitié environ de celle de la couche 16 de la figure 1 et qui est recouverte, par dépôt flash, d'une mince couche 24 d'un métal formant un siliciure, tel que le molybdène, le tungstène ou le titane, cette dernière couche étant recouverte à son tour d'une seconde couche 26 de polysilicium dont l'épaisseur est approximativement la même que celle de la couche 22. Un avantage important de la présente invention réside dans le fait que les trois couches 22, 24 et 26 peuvent être déposées au moyen des mêmes étapes de fabrication que dans le cas du procédé classique, c'est-à-dire que le dépôt des trois couches peut être effectué sans interrompre le vide et, par conséquent, en utilisant une seule étape de mise sous vide.

La structure composite à trois couches est ensuite délimitée au moyen d'étapes normales de masquage pour obtenir la porte (composée des couches 22, 24 et 26). L'étape de réoxydation est ensuite exécutée pour former la couche de dioxyde de silicium sur la couche 26, pendant cette étape la température élevée provoque une réaction entre la couche métallique 24 et les couches de polysilicium 22 et 26, avec deux fronts de réaction, pour former un siliciure présentant une conductivité de type métallique. La structure après réaction est schématiquement représentée sur la figure 2.

La présente invention n'est pas limitée à la fabrication d'une structure de porte pour transistor à effet de champ du type métal-oxyde-semi-conducteur, et peut être utilisée de façon plus générale, par exemple, pour réaliser des dispositifs bipolaires et des bandes conductrices ou conducteurs en polysilicium dans des circuits multicouches. Ainsi, des conducteurs en polysilicium peuvent être réalisés qui renferment une couche de siliciure, conformément aux principes de la présente invention, de manière à tirer parti d'une part des propriétés offertes par le polysilicium en ce qui concerne la stabilité aux températures élevées et sa facilité d'oxydation, et d'autre part de la faible résistance de feuille du siliciure.

D'autres, applications de la présente invention au domaine des circuits intégrés, comprennent les mémoires à cellules constituées par un dispositif unique et les ensembles logiques. La structure ici décrite, qui comporte une couche en siliciure, peut être utilisée dans les cellules à un seul dispositif pour maintenir une faible résistance de feuille de la ligne de bits sans pour autant augmenter la capacité de cette dernière, augmentant ainsi la sensibilité du dispositif qui résulte d'un meilleur couplage.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

### Revendications

1. Procédé de fabrication d'une structure composite de conducteurs pour circuits intégrés du genre comprenant les étapes suivantes:

élaboration d'un substrat isolant,

dépôt d'une première couche de polysilicium sur le substrat,

dépôt d'une couche d'un métal bon conducteur, susceptible de former un siliciure sur la première couche,

caractérisé en ce qu'il comporte en outre les étapes de:

dépôt d'une seconde couche de polysilicium sur la couche de métal,

masquage et décapage de la couche composite pour obtenir une configuration désirée de conducteurs,

chauffage de l'ensemble dans une atmosphère oxydante pour faire réagir le métal avec le polysilicium et le transformer en une couche de siliciure disposée entre deux couches de polysilicium, la deuxième couche de polysilicium étant partiellement oxydée.

2. Procédé de fabrication d'une électrode de porte d'un transistor à effet de champ à porte isolée et auto-alignée du genre comprenant les étapes suivantes:

dépôt d'une première couche de polysilicium sur l'isolant de porte,

dépôt d'une couche d'un métal bon conducteur susceptible de former un siliciure, caractérisé en ce qu'il comporte en outre les étapes suivantes:

dépôt d'une seconde couche de polysilicium sur la couche de métal,

masquage et décapage de la couche composite ainsi formée pour définir une structure composite de porte selon une configuration désirée et

chauffage de l'ensemble dans une atmosphère oxydante pour faire réagir le métal avec le polysilicium et le transformer en une couche de siliciure disposée entre deux couches de polysilicium, la deuxième couche de polysilicium étant partiellement oxydée.

## Patentansprüche

1. Verfahren zum Herstellen einer zusammengesetzten Leiterstruktur für integrierte Schaltkreise mit folgenden Verfahrensschritten:

— Bilden eines Isolatorsubstrats,

— Abscheiden einer ersten Polysiliciumschicht auf das Substrat,

— Abscheiden einer gutleitenden Metallschicht, die evt. auf der ersten Schicht ein Silicid bilden kann,

weiterhin durch folgende Verfahrensschritte gekennzeichnet:

— Abscheiden einer zweiten Polysiliciumschicht auf die Metallschicht,

— Maskieren und Ätzen der zusammengesetzten Schicht, um das gewünschte Leitermuster zu erhalten,

— Erhitzen der Anordnung in einer oxidierenden Atmosphäre, damit das Metall mit dem Polysilicium reagiert, um es in eine zwischen zwei Polysiliciumschichten liegende Silicisschicht zu verwandeln, wobei die zweite Polysiliciumschicht teilweise oxidiert wird.

2. Verfahren zum Herstellen einer Gateelektrode eines gateisolierten und selbstabgleichenden Feldeffekttransistors mit folgenden Verfahrensschritten:

— Abscheiden einer ersten Polysiliciumschicht auf den Gateisolator,

— Abscheiden einer gutleitenden Metallschicht, die evt. ein Silicid bilden kann,

weiterhin durch folgende Verfahrensschritte gekennzeichnet:

— Abscheiden einer zweiten Polysiliciumschicht auf die Metallschicht,

— Maskieren und Ätzen der so erhaltenen zusammengesetzten Schicht, um die zusammengesetzte Gatestruktur nach einem gewünschten Muster zu definieren, und

— Erhitzen der Anordnung in einer oxidierenden Atmosphäre, damit das Metall mit dem Polysilicium reagiert, um es in eine zwischen den zwei Polysiliciumschichten liegende Silicidschicht zu verwandeln, wobei die zweite Polysiliciumschicht teilweise oxidiert wird.

## Claims

1. Method for fabricating a composite conductor structure for integrated circuits including the following steps:

forming an insulator substrate,

depositing a first polysilicon layer on the substrate,

depositing a highly-conductive metal layer capable of forming a silicide on the first layer, characterized in that it further includes the steps of:

depositing a second polysilicon layer on the metal layer,

masking and etching the composite layer to obtain a desired conductor pattern,

heating the arrangement in an oxidizing atmosphere so that the metal reacts with the polysilicon in order to transform it into a silicide layer arranged between two polysilicon layers, the second polysilicon layer being partially oxidized.

2. Method for fabricating a gate electrode of a gate isolated, auto-aligned field effect transistor including the steps of:

depositing a first polysilicon layer on the gate insulator,

depositing a highly conductive metal layer capable of forming a silicide,

characterized in that it further includes the steps of:

depositing a second polysilicon layer on the metal layer,

masking and etching the composite layer thus obtained to define a composite gate structure according to the desired pattern, and

heating the arrangement in an oxidizing atmosphere so that the metal reacts with the polysilicon in order to transform it into a silicide layer arranged between two polysilicon layers, the second polysilicon layer being partially oxidized.

# FIG. 1

# FIG. 2